(19) Europäisches Patentamt
European Patent Office
Office européen des brevets

(11) Veröffentlichungsnummer: **0 393 551 A2**

# (12) EUROPÄISCHE PATENTANMELDUNG

(21) Anmeldenummer: **90107154.8**

(22) Anmeldetag: **14.04.90**

(51) Int. Cl.5: **C08J 7/04**

(30) Priorität: **17.04.89 DE 3912533**

(43) Veröffentlichungstag der Anmeldung: **24.10.90 Patentblatt 90/43**

(84) Benannte Vertragsstaaten: **AT BE CH DE DK ES FR GB IT LI NL SE**

(71) Anmelder: **BASF Aktiengesellschaft**
**Carl-Bosch-Strasse 38**
**D-6700 Ludwigshafen(DE)**

(72) Erfinder: **Fuchs, Harald, Dr.**
**Boehlweg 32**
**D-6719 Carlsberg(DE)**
Erfinder: **Fuchhoff, Dirk, Dr.**
**Panoramastrasse 3a**
**D-6900 Heidelberg(DE)**
Erfinder: **Licht, Ulrike, Dr.**
**Meerfeldstrasse 62**
**D-6800 Mannheim 1(DE)**
Erfinder: **Schrepp, Wolfgang, Dr.**
**Sitzbuchweg 114**
**D-6900 Heidelberg(DE)**

## (54) Verfahren zur Herstellung von gleichmässigen dünnen Schichten.

(57) Die Erfindung betrifft ein Verfahren zur Herstellung von gleichmäßigen dünnen Schichten.

Diese Schichten weisen Schichtdicken zwischen 40 Å und 1 µm auf, sind gegenüber Sauerstoffplasma ätzstabil und lassen sich mittels Langmuir-Blodgett- oder Self-Assembly-Technik auf das Substrat auftragen.

EP 0 393 551 A2

## Verfahren zur Herstellung von gleichmäßigen dünnen Schichten

Die Erfindung betrifft ein Verfahren zur Herstellung von gleichmäßigen dünnen Schichten nach der Langmuir-Blodgett- oder Self-Assembly-Technik, wobei plasma-ätzstabile Schichten entstehen.

Für dünne organische Schichten, welche nach der Langmuir-Blodgett-(LB)-Technik (vgl. H. Kuhn, D. Möbius und H. Bücher, Physical Methods of Chemistry, Teil III B, Weissberger und Rossiter (Hrsg.), Wiley, New York 1972, S. 577 ff.) oder dem Self-Assembly-(=SA)-Verfahren, d.h. der Selbstadsorption (vgl. R. Pommerantz, A. Segmüller, L. Netzer und J. Sagiv, Thin Solid Films 132 (1985) 153) hergestellt werden, gibt es weitgefächerte Perspektiven für Anwendungen in Hochtechnologie-Bereichen (vgl. G.G. Roberts, Adv. Phys. 34 (1985) 475). Eine Reihe von Anwendungen für den Halbleiterbereich z. B. für Isolations- oder Resistschichten, wie auch als aktive Materialien für Sensoren wurden prognostiziert. Untersuchungen zur für den Halbleiterbereich wichtigen Plasmaätzstabilität sind nur sehr spärlich durchgeführt worden (vgl. A. Barraud, Thin Solid Films 99 (1983) 317). Hierbei zeigt sich, daß die dünnen organischen Schichten insbesondere gegenüber Sauerstoff-Plasma nur eine geringe Ätzstabilität aufweisen.

Diese fehlende Eigenschaft schränkt ihre Verwendung in der Mikrolithographie stark ein, obwohl LB-Filme z.B. durch die mit ihnen definiert einzustellende Schichtdicke ideale Kandidaten für Resists mit sehr dünnen Schichtdicken wären.

Es ist daher wünschenswert, Substanzen darzustellen, die einerseits LB-Schichten bzw. Schichten nach der SA-Technik bilden können, und andererseits ätzstabil sind.

Die erfindungsgemäß hergestellten dünnen Schichten mit Schichtdicken bis hinunter in den Å-Bereich sind deutlich plasmaätzstabiler als konventionelle Schichten, die kein Silicium enthalten.

LB-fähige Polysiloxane sind z.B. von N. Carr und M.J. Goodwin (vgl. N. Carr und M.J. Goodwin, Makromol. Chem., Rapid Commun. 8 (1987) 497) beschrieben. Allerdings wurden hierin nur die nichtlinearen optischen Eigenschaften einer Monoschicht untersucht. Derartige Monoschichten sind jedoch nicht genügend ätzstabil.

In EP-A-0231497 sind Polysiloxane beschrieben, die in den Seitenketten alkali-lösliche phenolische Hydroxy-Gruppen oder Carboxyl-Gruppen enthalten. Die dort beschriebenen Verbindungen sind jedoch nicht in der Lage, LB- oder SA-Schichten zu bilden, da die verwendeten Kettenlängen zu kurz sind. Gleiches gilt für die in EP-A-0204963 beschriebenen alkali-löslichen Polysiloxane.

Aufgabe der vorliegenden Erfindung ist es, ein Verfahren aufzuzeigen, mit dem sich gegenüber Sauerstoffplasma ätzstabile dünne Schichten siliciumhaltiger Verbindungen, die entweder einen monomolekularen LB-Film bilden können, der sich auf ein Substrat übertragen läßt und den Aufbau mehrerer Schichten erlaubt und/oder die nach der SA-Technik übertragbar sind, herstellen lassen.

Durch die in der vorliegenden Patentanmeldung beschriebenen siliciumhaltigen Verbindungen wird die erfindungsgemäße Aufgabe gelöst, ätzstabile Schichten nach der LB- oder SA-Technik herstellen zu können.

Gegenstand der vorliegenden Erfindung ist ein Verfahren zur Herstellung von gleichmäßigen dünnen Schichten mit Schichtdicken zwischen 40 Å und 1 µm auf einem Substrat, das dadurch gekennzeichnet ist, daß siliciumhaltige Verbindungen, die gegenüber Sauerstoffplasma ätzstabil sind, mittels Langmuir-Blodgett- oder Self-Assembly-Technik auf das Substrat aufgetragen werden.

Bevorzugt als siliciumhaltige Verbindungen sind Polysilane oder Polysiloxane mit einem Siliciumgehalt von >4 Gewichtsprozent, insbesondere Polysiloxane, z.B. solche mit Gruppen der allgemeinen Formel (I)

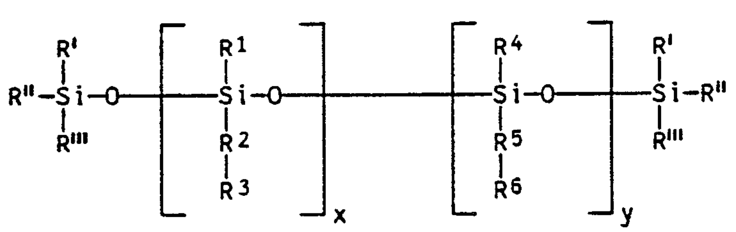

(I),

worin

$R'$, $R''$ und $R'''$ untereinander gleich oder verschieden sind und für Alkylreste mit 1 bis 4 Kohlenstoffatomen oder Arylreste mit 6 bis 10 Kohlenstoffatomen,

$R^1$ und $R^4$ untereinander gleich oder verschieden sind und für, gegebenenfalls halogeniertes, Alkyl, Oxaalkyl, Thiaalkyl, Aryl, Heteroaryl oder Alkaryl stehen,

$R^2$ und $R^5$ untereinander gleich oder verschieden sind und für einen zweiwertigen, gegebenenfalls halogenierten, Alkylen-, Oxaalkylen-, Thiaalkylen-, Arylen-, Heteroarylen- oder Alkarylenrest stehen,
$R^3$ und $R^6$ untereinander gleich oder verschieden sind und für OH, COOH, CN, $NH_2$, SH, COSH, CSOH, CSSH, $SO_3H$, $SO_3^{\ominus}$, $COO^{\ominus}$, $CONH_2$, $CSNH_2$ oder $NO_2$ stehen, sowie für den Fall, daß $R^3$ und $R^6$ untereinander verschieden sind, einer der Reste $R^3$ oder $R^6$ für H stehen kann,
x und y untereinander gleich oder verschieden sind, mit der Maßgabe, daß x für Zahlen von 0 bis 1000 steht, falls $R^6 \neq H$ ist, und für Zahlen von 5 bis 1000 steht, falls $R^6 = H$ und $R^3 \neq H$ ist, und
y für Zahlen von 0 bis 1000, falls $R^3 \neq H$, und für Zahlen von 5 bis 1000, falls $R^3 = H$ und $R^6 \neq H$.

Derartige modifizierte Polysiloxane lassen sich beispielsweise durch Hydrosilylierung geeigneter ethylenisch ungesättigter Verbindungen mit Polyhydrosiloxanen oder Copolymeren, die Einheiten der allgemeinen Formel (II)

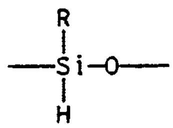

(II),

worin R die Bedeutung von $R^1$ oder $R^4$ hat, enthalten, erhalten. Derartige Polyhydrosiloxane oder Copolymere sind auch kommerziell erhältlich.

Gegenstand der vorliegenden Erfindung ist außerdem ein Verfahren zur Herstellung elektronischer Bauteile durch Strukturierung dünner Schichten mittels Bestrahlung, wobei dünne Schichten siliciumhaltiger Verbindungen mit Schichtdicken zwischen 40 Å und 1 µm, die nach dem erfindungsgemäßen Verfahren hergestellt worden sind, eingesetzt werden.

Gegenstand der vorliegenden Erfindung ist auch die Verwendung dünner Schichten siliciumhaltiger Verbindungen mit Schichtdicken zwischen 40 Å und 1 µm, die nach dem erfindungsgemäßen Verfahren erhalten worden sind, für die Mikrolithographie.

Nach dem erfindungsgemäßen Verfahren lassen sich mittels LB- oder SA-Technik gegenüber Sauerstoffplasma ätzstabile gleichmäßige dünne Schichten mit Schichtdicken zwischen 40 Å und 1 µm herstellen, die sich sehr vorteilhaft strukturieren lassen und aufgrund der geringen Schichtdicke und der Möglichkeit des Plasmaätzens eine hohe Auflösung beim Strukturieren ergeben.

Zum erfindungsgemäßen Verfahren und den dazu verwendeten Materialien ist im einzelnen folgendes zu sagen.

Als erfindungsgemäß einzusetzende siliciumhaltige Verbindungen eignen sich vorzugsweise Polysilane oder Polysiloxane mit einem Siliciumgehalt von >4 Gewichtsprozent, insbesondere Polysiloxane, beispielsweise Verbindungen, die Gruppen der allgemeinen Formel (I) enthalten, insbesondere solche, die im wesentlichen aus diesen Gruppen bestehen,

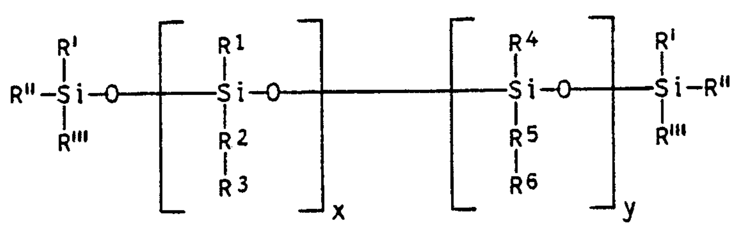

(I),

wobei die allgemeine Formel (I) sowohl statistische Copolymere als auch Blockcopolymere umfaßt.

In dieser Formel sind
$R'$, $R''$, $R'''$ untereinander gleich oder verschieden und stehen für Alkylreste mit 1 bis 4 Kohlenstoffatomen, wie z.B. Methyl, Ethyl, Propyl oder Butyl, vorzugsweise Methyl, oder Arylreste mit 6 bis 10 Kohlenstoffatomen, wie Phenyl oder Tolyl, vorzugsweise Phenyl.

Bevorzugt sind solche Polysiloxane der Formel (I), worin
$R^1$ und $R^4$ untereinander gleich oder verschieden sind und für Alkylgruppen mit 1 bis 4 Kohlenstoffatomen, beispielsweise Methyl-, Ethyl-, Propyl-, Butyl-, vorzugsweise Methyl- oder Ethylgruppen oder für Arylgruppen, wie z.B. Phenylgruppen stehen,
$R^2$ und $R^5$ können untereinander gleich oder verschieden sein und für zweiwertige Reste, beispielsweise Alkylenreste mit 10 bis 20, vorzugsweise 10 bis 16 Kohlenstoffatomen, entsprechende Oxaalkylen-, Thiaalkylen-, Arylen-, Heteroarylen-, oder Alkarylenreste stehen, beispielsweise an $-C_3-$ bis $-C_{10}-$, $-C_3-$ bis

$-C_{10}$-O- oder $-C_3$- bis $-C_{10}$-S- gebundene Biphenyl-, Stilben-oder Azobenzolreste, an die wiederum $-C_1$- bis $-C_6$-Alkylen-, Oxaalkylen- oder Thiaalkylenreste gebunden sein können, wobei an Aromaten gebundene $-C_4$- bis $-C_6$-Alkylenreste bevorzugt sind.

$R^3$ und $R^6$ sind untereinander gleich oder verschieden und können für polare Gruppen, wie OH, COOH, CN, $NH_2$, SH, COSH, CSOH, CSSH, $SO_3H$, $SO_3^{\ominus}$, $COO^{\ominus}$, $CONH_2$, $CSNH_2$ oder $NO_2$ stehen, sowie für den Fall, daß $R^3$ und $R^6$ untereinander verschieden sind, kann einer der Reste $R^3$ oder $R^6$ für H stehen. $R^3$ und/oder $R^6$ stehen bevorzugt für OH, COOH, SH und $NH_2$, insbesondere OH, SH und COOH.

x und y können untereinander gleich oder verschieden sein, mit der Maßgabe, daß x für Zahlen von 0 bis 1000 steht, falls $R^6 \neq H$ ist, und für Zahlen von 5 bis 1000 steht, falls $R^6 = H$ und $R^3 \neq H$ ist, und y für Zahlen von 0 bis 1000, falls $R^3 \neq H$, und für Zahlen von 5 bis 1000, falls $R^3 = H$ und $R^6 \neq H$.

$R^1$, $R^2$, $R^4$ und/oder $R^5$ können auch halogeniert sein, d.h. F-, Cl- oder Br-Substituenten tragen, wobei Fluor als Substituent, insbesondere perfluorierte Reste bevorzugt sind.

Die Darstellung derartiger Polysiloxane kann, wie oben bereits erwähnt, z.B. durch Umsetzung eines entsprechend substituierten Polyhydrosiloxanes mit einer an der polaren Gruppe geschützten, eine terminale Doppelbindung enthaltenden, die Seitengruppe bildenden Verbindung beispielsweise analog folgender allgemeiner Reaktionsgleichung erfolgen:

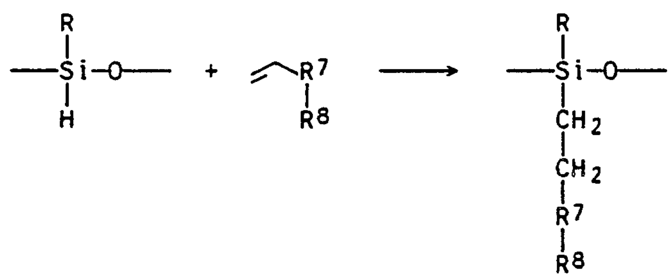

worin

$R^7$ = alkylen-, arylen-, alkarylen-,

$R^8$ = -O-Sch, -S-Sch, wobei Sch eine Schutzgruppe der -OH- bzw. -SH-Funktion bedeutet.

R hat die Bedeutung von $R^1$ oder $R^4$.

Beispiele für derartige an der polaren Gruppe geschützte, eine terminale Doppelbindung enthaltende Verbindungen sind

$CH_2=CH(CH_2)n\text{-}O\text{-}Si(CH_3)_3$ mit n = 8 bis 18

oder 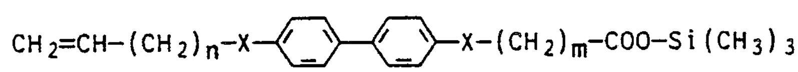

mit n = 1 bis 8

m = 0 bis 6

X = O, S, $CH_2$ oder eine Einfachbindung,

die nach üblichen Methoden der organischen Chemie erhältlich sind.

Die Abspaltung der Schutzgruppe kann in geeigneter üblicher Weise, beispielsweise durch schwache Säuren oder Basen erfolgen. Als Schutzgruppen kommen in Frage z.B. Gruppierungen der Formeln $-SiR_3$, z.B. Trimethylsilyl, $-O-\overset{\overset{\displaystyle O}{\|}}{C}-R$ und -O-R ,

d.h. Ester-, Ether- sowie Acetal- und Halbacetal-gruppierungen.

Die LB-Schichten werden in der üblichen Weise durch sukzessive Übertragung von Monoschichten von einer wäßrigen Subphase hergestellt. Hierzu wird eine Lösung der betreffenden Substanz oder auch eine Substanzmischung auf der Wasseroberfläche des Langmuir-Troges gespreitet und eine komprimierte Monoschicht hergestellt. Die Übertragung erfolgt mittels Durchtauchen geeigneter gereinigter Träger durch die filmbedeckte Wasseroberfläche.

Eine umfassende Literaturübersicht ergibt sich z.B. aus Tagungsbänden zu drei Konferenzen über Langmuir-Blodgett-Filme, die in den folgenden Bänden von Thin Solid Films erschienen sind: 160 (1988), 159 (1988), 132-134 (1985) und 99 (1983), sowie aus "Molecular Engineering using the Langmuir-Blodgett-Technique" von M.C. Petty in Polymer Surfaces and Interfaces, Edited by W. Feast and H.S. Munro (1987) John Wiley & Sons Ltd, Seiten 163-187.

Self-Assembly-Schichten werden durch einmaliges oder wiederholtes Eintauchen des zu beschichtenden Substrats in verdünnte Lösungen der aufzubringenden Verbindung hergestellt. Im allgemeinen werden schnell verdampfende, organische Lösungsmittel verwendet. Eine Beschreibung der Self-Assembly-Technik findet sich z.B. in R. Maoz und J. Sagiv, Thin Solid Films, 132 (1985) 135 und der dort zitierten Literatur.

Die beschriebenen Schichten können z.B. als Schutz-, Isolations-, Gleit-und Resistschichten Verwendung finden. Auch eine Anwendung als oberste Schichten bei Mehrlagenresists ist möglich.

Durch Verwendung von Licht im sichtbaren oder ultravioletten Spektralbereich oder durch Elektronen-, Ionen- oder Röntgenstrahlung können die erfindungsgemäß hergestellten Schichten strukturiert werden. Hierbei ist eine Belichtung durch Masken oder im direkten Schreibverfahren möglich.

Die im Beispiel angegebenen Prozente sind Gewichtsprozente.

## Beispiel

7,59 g (d.h. mit 32,7 mmol Si-H) eines Poly(octylmethyl)(methylhydro)-siloxan-Copolymeren (mittleres Molekulargewicht $\overline{M}_n$ = 4100) wurden in 30 ml Toluol unter Stickstoffatmosphäre gelöst, mit 8,20 g (35,95 mmol) 1-Decen-10-ol-trimethylsilylether und 0,3 ml einer Lösung von Hexachloroplatinsäure in Tetrahydrofuran versetzt. Nach Erhitzen der Lösung über Nacht auf 80 °C wurde über Kieselgel filtriert und die erhaltene, vom Platin befreite Lösung am Rotationsverdampfer eingeengt; es ergaben sich 12,4 g (83 %). klares Öl.

5,52 g dieser Substanz wurden in Tetrahydrofuran (=THF) gelöst und mit Eisessig versetzt. Nach Stehenlassen über Nacht wurden die Lösungsmittel im Vakuum abdestilliert. Der Rückstand wurde gelchromatographisch (z.B. über Sephadex/THF) gereinigt und die erhaltene Lösung im Vakuum vom Lösungsmittel befreit. Zurück blieben 4,53 g (97 %) des gewünschten Polysiloxans (1) mit einem Polymerisationsgrad von ca. 34.

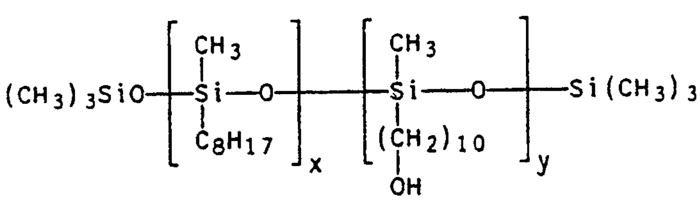

$x = y \approx 17$

IR-Spektrum: 3350 $cm^{-1}$ (OH), 2950 (CH), 2900 (CH), 2850 (CH), 1470 (OH), 1260 ($Si-CH_3$), 1100-1000 (Si-O-Si).

$^1$H-NMR-Spektrum: $\delta$ = 3.51 (m, 2 H; $CH_2$-OH), 1.45 (m, 2 H; $CH_2$-$CH_2$-OH), 1.18 (m; 22 H, restl. Alkyl-Kette), 0.79 (t, J = 9 Hz; 3 H, $CH_2$-$CH_3$), 0.40 (m; 4 H, Si-$CH_2$-$CH_2$-), -0.01 (m; 10 H; Si-$CH_2$-, Si-$CH_3$).-(Die Interpretation basiert auf je einer der beiden mit dem Index x und y bezeichneten Wiederholungseinheiten der Formel I).

Das Druck/Flächen-Diagramm (mN/m gegen Å$^2$/Molekül) des Polysiloxans (1) ist in Fig. 1 gezeigt. Es wurde auf einem kommerziellen Langmuir-Trog bei Verwendung von Wasser bei 20,5 °C als Subphase aufgenommen. Zum Spreiten wurde eine $10^{-3}$ molare Lösung in Chloroform verwendet. Die Übertragung auf feste Träger erfolgte nach der Langmuir-Blodgett-Technik.

Als Träger eignen sich Halbleitermaterialien, wie z.B. Siliciumwafer, oder auch Polymere, wie z.B. Polyimide.

Die Schichten nach der SA-Technik wurden durch Eintauchen und anschließendes, langsames Herausziehen aus verschieden konzentrierten Lösungen hergestellt. Hierbei entstehen je nach Konzentration und Tauchzeit Monoschichten oder auch dickere Schichten (durch Mehrfachadsorption z.T. 30 oder 50 nm aus Lösungen von $10^{-3}$ - $10^{-1}$ mol/l).

Zur Untersuchung der Plasmaätzstabilität wurden LB-Multischichten (z.B. 10, 20 oder 30 Schichten) oder SA-Schichten auf Silicium-Wafern hergestellt und in einem kommerziellen Plasmareaktor bei 20 W Plasmaleistung u.a. in Sauerstoff untersucht. Die Ergebnisse sind in Fig. 2 gezeigt. Figur 2 zeigt die Schichtdickenabnahme im Sauerstoff-Plasma (Schichtdicke in nm gegen Zeit in Minuten), wobei jeweils 10 (Δ), 20 (o) und 30 (●) LB-Schichten untersucht wurden, und zwar von:

a) Polyamidsäure-Octadecylammoniumsalz = Vergleichssubstanz 1,
b) Vergleichssubstanz 2,
c) Polysiloxan (1) (erfindungsgemäß).

Es wird deutlich, daß z.B. die Siloxanschichten (2c) eine deutlich höhere Plasmaätzstabilität aufweisen, als solche, die kein oder weniger als 4 % Silicium aufweisen (vgl. Tabelle 1).

Die erfindungsgemäß hergestellten dünnen Schichten können auch durch UV-Licht oder Elektronenstrahlen strukturiert werden. Als Beispiel wurde das Polysiloxan (1) mit Licht der Wellenlänge von 254 nm bestrahlt. In den bestrahlten Bereichen wird die Schicht unlöslich in Alkohol, die unbestrahlten Bereiche bleiben löslich. In diesem Fall wirkt die Polysiloxanschicht als Negativ-Resist.

Tabelle 1

Strukturformel der erfindungsgemäß verwendeten Substanzen:

Bezeichnung

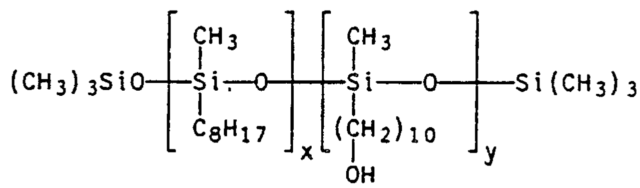

Polysiloxan (1)

x = y ≈ 17

Vergleichssubstanzen:

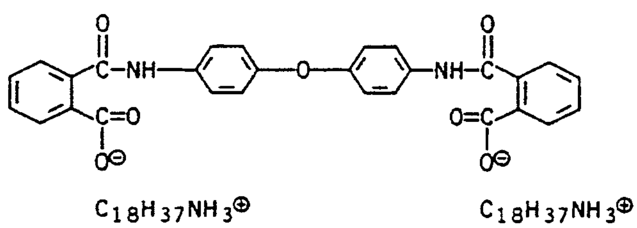

= Vergleichssubstanz 1

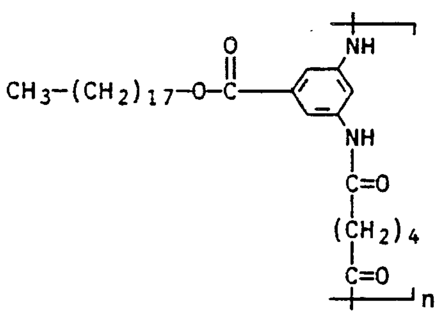

= Vergleichssubstanz 2

$M_w$ (gemessen nach Lichtstreuung): 43.000.

## Ansprüche

1. Verfahren zur Herstellung von gleichmäßigen dünnen Schichten mit Schichtdicken zwischen 40 Å und 1 µm auf einem Substrat, dadurch gekennzeichnet, daß siliciumhaltige Verbindungen, die gegenüber Sauerstoffplasma ätzstabil sind, mittels Langmuir-Blodgett- oder Self-Assembly-Technik auf das Substrat aufgetragen werden.

2. Verfahren nach Anspruch 1, dadurch gekennzeichnet, daß als siliciumhaltige Verbindungen Polysilane oder Polysiloxane mit einem Siliciumgehalt von >4 Gewichtsprozent eingesetzt werden.

3. Verfahren nach einem der vorhergehenden Ansprüche, dadurch gekennzeichnet, daß als siliciumhaltige Verbindungen solche mit Gruppen der allgemeinen Formel (I)

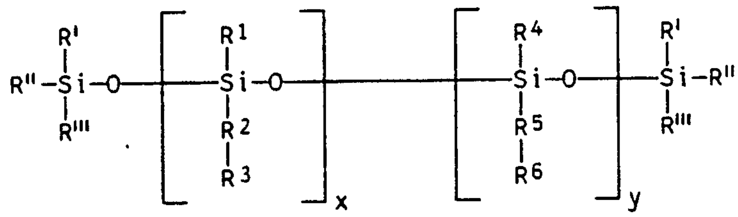

(I)

eingesetzt werden, worin

$R'$, $R''$, $R'''$ untereinander gleich oder verschieden sind und für Alkylreste mit 1 bis 4 Kohlenstoffatomen oder Arylreste mit 6 bis 10 Kohlenstoffatomen,

$R^1$ und $R^4$ untereinander gleich oder verschieden sind und für, gegebenenfalls halogeniertes, Alkyl, Oxaalkyl, Thiaalkyl, Aryl, Heteroaryl oder Alkaryl stehen,

$R^2$ und $R^5$ untereinander gleich oder verschieden sind und für einen zweiwertigen, gegebenenfalls halogenierten, Alkylen-, Oxaalkylen-, Thiaalkylen-, Arylen-, Heteroarylen- oder Alkarylenrest stehen,

$R^3$ und $R^6$ untereinander gleich oder verschieden sind und für OH, COOH, CN, $NH_2$, SH, COSH, CSOH, CSSH, $SO_3H$, $SO_3^{\ominus}$, $COO^{\ominus}$, $CONH_2$, $CSNH_2$ oder $NO_2$ stehen, sowie für den Fall, daß $R^3$ und $R^6$ untereinander verschieden sind, einer der Reste $R^3$ oder $R^6$ für H stehen kann,

x und y untereinander gleich oder verschieden sind, mit der Maßgabe, daß x für Zahlen von 0 bis 1000 steht, falls $R^6 \neq H$ ist, und für Zahlen von 5 bis 1000 steht, falls $R^6 = H$ und $R^3 \neq H$ ist, und

y für Zahlen von 0 bis 1000, falls $R^3 \neq H$, und für Zahlen von 5 bis 1000, falls $R^3 = H$ und $R^6 \neq H$.

4. Verfahren zur Herstellung elektronischer Bauteile durch Strukturierung dünner Schichten mittels Bestrahlung, dadurch gekennzeichnet, daß dünne Schichten siliciumhaltiger Verbindungen mit Schichtdicken zwischen 40 Å und 1 µm, die nach einem Verfahren gemäß einem der vorhergehenden Ansprüche hergestellt worden sind, eingesetzt werden.

5. Verwendung dünner Schichten siliciumhaltiger Verbindungen mit Schichtdicken zwischen 40 Å und 1 µm, die nach einem Verfahren gemäß einem der Ansprüche 1 bis 4 erhalten worden sind, für die Mikrolithographie.

FIG. 1

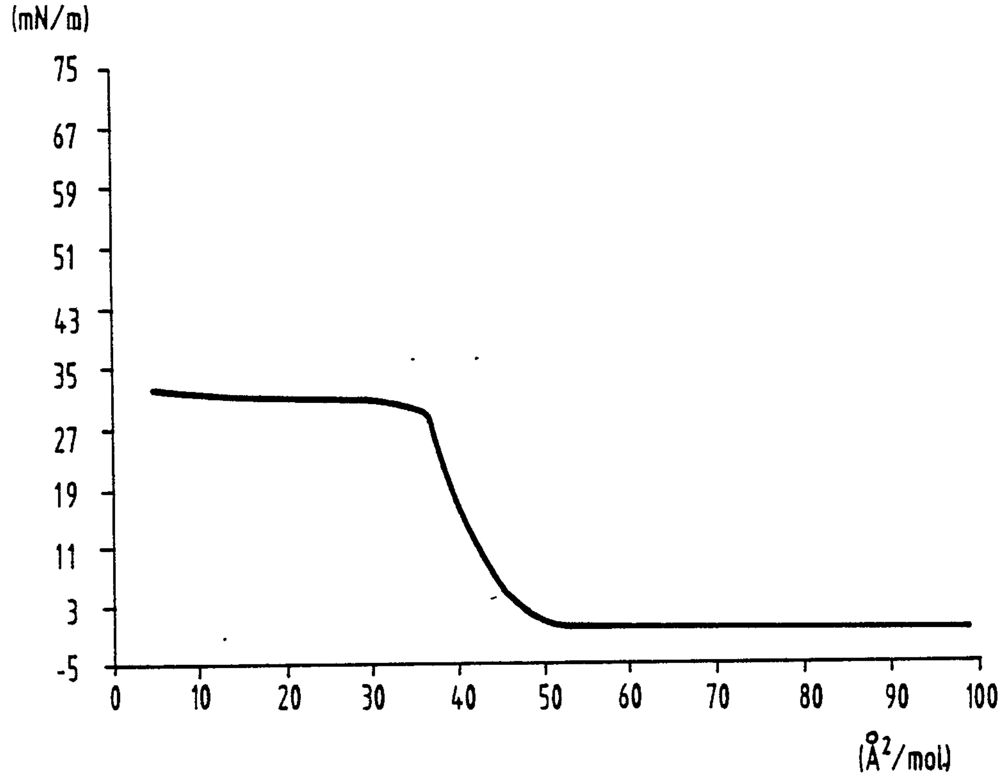
(mN/m)
75
67
59
51
43
35
27
19
11
3
-5
0
10
20
30
40
50
60
70
80
90
100
(Å²/mol)

FIG. 2

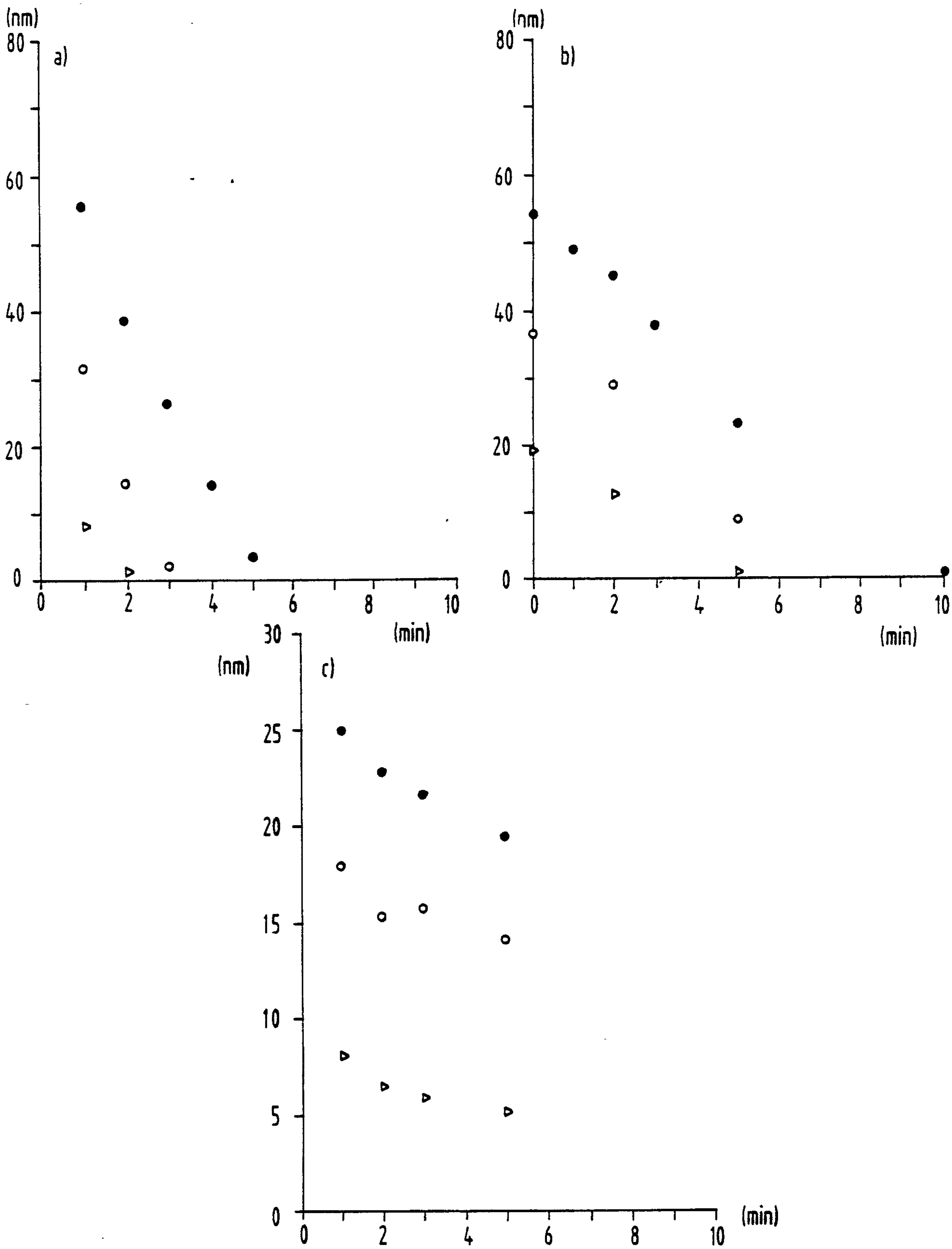
(nm)
80
60
40
20
0
a)
0
2
4
6
8
10
(min)
(nm)
80
60
40
20
0
b)
0
2
4
6
8
10
(min)
30
(nm)
25
20
15
10
5
0
c)
0
2
4
6
8
10
(min)

787/88